Europäisches Patentamt

European Patent Office

Office européen des brevets

(19)

(11) Publication number: **0 089 472**
**A1**

(12) **EUROPEAN PATENT APPLICATION**

(21) Application number: **83100911.3**

(22) Date of filing: **01.02.83**

(51) Int. Cl.³: **G 01 J 3/28**

(30) Priority: **19.03.82 US 360097**

(43) Date of publication of application:
**28.09.83 Bulletin 83/39**

(84) Designated Contracting States:
**DE FR GB**

(71) Applicant: **International Business Machines
Corporation
Old Orchard Road
Armonk, N.Y. 10504(US)**

(72) Inventor: **Bjorklund, Gary Carl
1201 Eureka Avenue
Los Altos California 94022(US)**

(72) Inventor: **Hunziker, Heinrich Erwin
P.O. Box 2807
Saratoga California 95070(US)**

(74) Representative: **Ahlman, Bertel
IBM Svenska AB Box 962
S-18 109 Lidingö(SE)**

(54) **Method for spectral analysis of short optical pulses.**

(57) A method for the spectral analysis of short optical pulses (12) uses an optical group velocity dispersive medium (14), for example, a low loss single mode optical fiber, to map the optical spectrum (a) of the pulse into the time domain (c, d). One application of this method is used for obtaining a serial, time domain readout of information stored in a photochemical hole burning memory which utilizes a medium with broad hole widths.

FIG.1

EP 0 089 472 A1

Method for spectral analysis of short optical pulses.

This invention relates to a method for the spectral analysis of short pulses and more particularly to the use of such a method for a spectral analysis of a sample.

In the past spectrometers have used mechanical manipulation of the grating or prism element. Mechanical manipulation has been replaced by an electronic readout such as described in the patent to Moore, U.S. 4,146,332. That patent describes scanning the spectrum electronically with an array detector consisting of light-sensitive, charge-coupled devices. The use of electronic processing then combines the information from the charge-coupled devices to provide a complete spectrum analysis. This approach, which is not based on time dispersion of the optical signal, is standard technology being used today. This technology, however, is expensive and slow, i.e. it takes milliseconds to describe a spectrum.

Another approach described in the patent to deNuy, U.S. 3,586,440 and the patent to Wentz, U.S. 4,042,302 maps the optical frequency into intensity. Wentz uses a broad band optical discriminator for determining the wavelength of received radiation which is in a narrow band. The received radiation is passed through a polarization spoiler, a linear polarizer, a polarization dispersion device and a beamsplitting polarizer forming two beams. The intensity of the two beams is converted into electrical signals. The electrical signals are processed to provide a signal indicative of the wavelength of the incident radiation. This method is also not based upon time dispersion of the optical signal.

0089472

The patent to Touvet, U.S. 2,745,311, describes a different approach in which the optical frequency is mapped into the time domain. This method requires a mechanical rotation of a prism which is not applicable to short pulses because it takes tens of milliseconds to describe a spectrum.

The invention as claimed is intended to overcome the problems of prior art methods.

The present invention discloses a method for the spectral analysis of short optical pulses that uses an optical group velocity dispersive medium to map the spectrum of the optical pulse into the time domain. This pulse contains information in the form of a complicated variation of the optical power contained in each region of the optical frequency spectrum. Such information can either (a) be present in the original pulsed light source or (b) it can be impressed on the optical pulse as it is passed through a medium whose optical absorption is a complicated function of optical frequency. In a preferred embodiment of type (b) the pulsed light source consists of a mode-locked laser whose output is focused into a non-linear medium, passed through the sample, passed through a low-loss, single mode fiber, and then passed to a fast photodetector. One application of this method is used for obtaining a serial, time domain readout of information stored in a photochemical hole burning memory which utilizes a medium with broad hole widths.

An advantage of this invention is to provide an improved method for the spectral analysis of short optical pulses.

Another advantage of this invention is to provide a method for reading information stored in a photochemical hole burning memory.

The invention will now be described with reference to the accompanying drawings.

FIGURE 1 is a schematic of the method as applied for analysis of spectral content of a short light pulse together with frequency and time domain illustrations;

FIGURE 2 is a schematic of the method as applied for the readout of information contained in a complicated absorption spectrum together with frequency and time domain illustrations;

FIGURE 3 is a schematic of a preferred embodiment of this invention; and

FIGURE 4 contains frequency and time domain illustrations of the use of this invention in the readout of a photochemical hole burning memory.

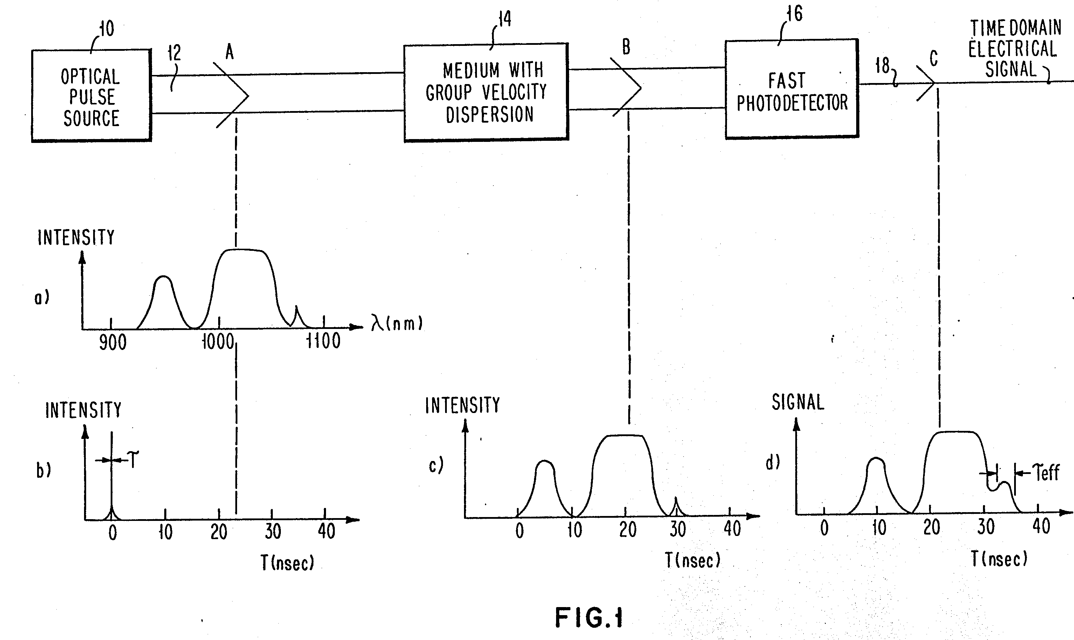

This method for the spectral analysis of short optical pulses uses an optical group velocity dispersion medium to map the spectrum of the optical pulse into the time domain. As shown in Figure 1, an optical pulse source 10, such as a laser, generates an optical pulse 12 having a pulsewidth $\tau$. The spectrum of the pulse in the optical frequency domain and in the time domain is shown in the diagrams associated with the dashed line at point A. The optical pulse 12 is then passed through an optical group velocity dispersive medium 14. Examples of a group velocity dispersive medium are a low loss, single mode optical fiber, which is a preferred medium, as well as rubidium vapor. Other media 14 that may be used are other vapors with absorption lines close to the mean wavelength of the input pulse. The medium 14 changes the information that was in the optical frequency spectrum into the time domain spectrum such as that shown in the diagram associated with the dotted line from point B. The optical pulse emerging from medium 14 is then passed into a fast photodetector 16. The photodetector signal 18 will reproduce in the time domain the optical power spectrum of the input pulse. The corresponding time domain electrical signal associated with point C is shown in the diagram at the end of the dashed line. In order for this method to work, the dispersive medium must have losses low enough to permit the propagation of detectable amount of optical intensity through distances long enough to produce the desired equivalent spectral resolution. In addition, the optical pulses, when propagating through the dispersive medium, must not be distorted by nonlinear optical effects such as self phase modulations. Nondistorted propagation of optical pulses through several Km of optical fiber has been demonstrated by D.M. Bloom et al, Optics Letter 4(9), 297 (1979).

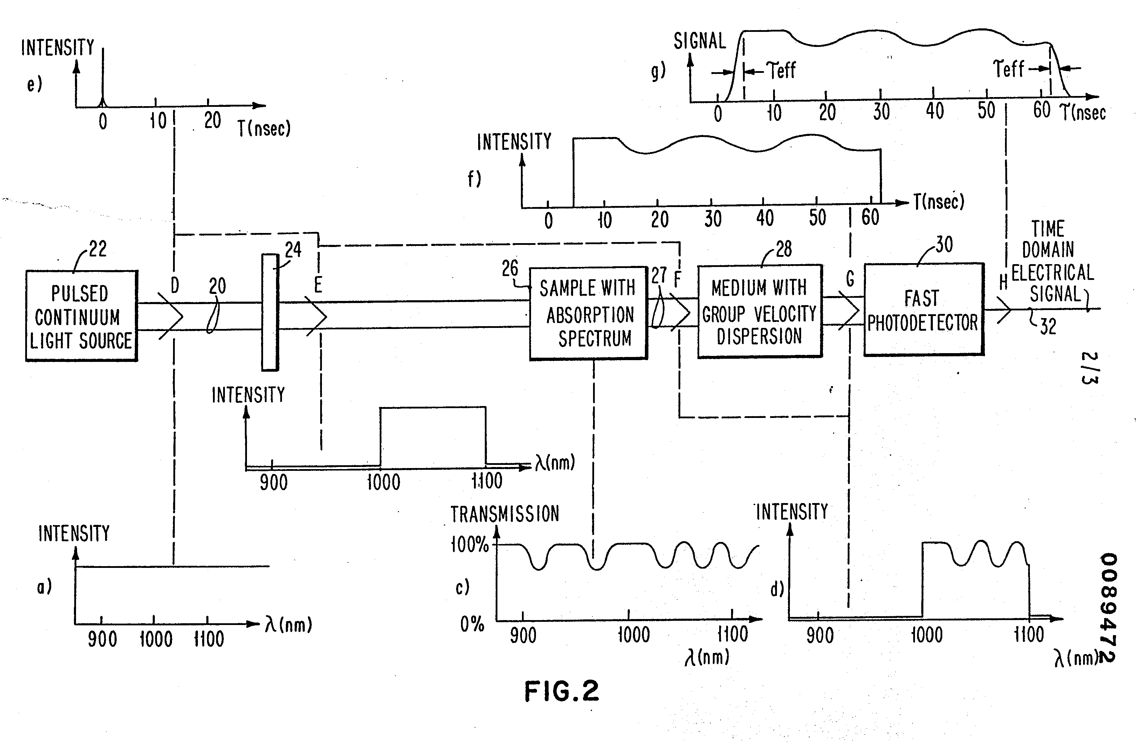

Figure 2 shows a method as it would apply to the readout of information contained in a complicated optical absorption spectrum. A beam of light 20 from a pulsed continuum source 22 (pulsewidth $\tau$) is passed through a band pass filter 24 and then impinges upon the sample 26 containing the optical absorption spectrum of interest. The band pass filter restricts the spectrum of the continuum to the desired spectral region as shown by the intensity-frequency plot diagram associated with the dashed line at E. The light 27 emerging from the sample 26 is passed through the group velocity dispersion medium 28 and onto the photodetector 30. The photodetector signal will reproduce in the time domain the optical spectrum of the sample. The equivalent spectral resolution $\delta\lambda$ obtained by this method is

$$\delta\lambda = \frac{\tau_{eff}V_G^2}{L\left(\frac{\delta V_G}{\delta\lambda}\right)} \; ,$$

where $V_G$ is the group velocity, $\frac{\delta V_G}{\delta\lambda}$ is its group velocity dispersion with respect to wavelength, L is the length of the dispersion medium, and $\tau_{eff}$ is the longer of either the laser pulse length $\tau$ or the photodetector response time. The intensity-time domain and intensity-frequency spectra per points D, E, F, G and H are set forth in the diagrams associated with the appropriate dashed lines.

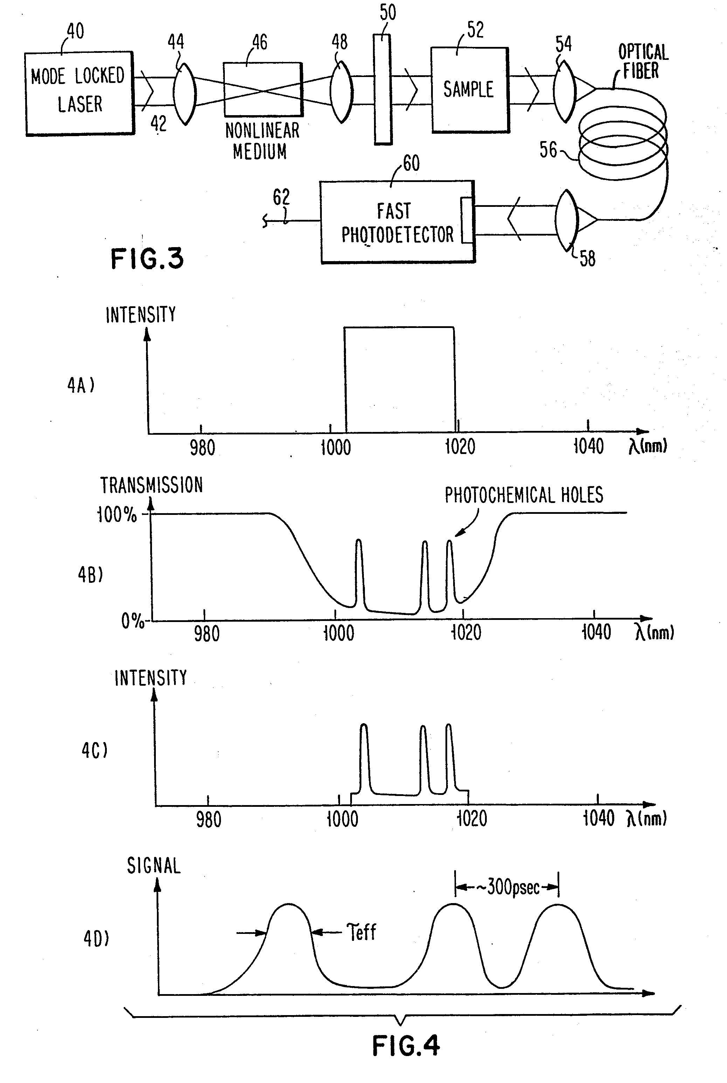

A preferred embodiment of this method is shown in Figure 3. The pulsed continuum source is provided by a mode-locked laser passing a short laser pulse 42 through a lens 44 and through a suitable nonlinear medium 46. The pulse is then passed through another lens 48 and through an interference filter 50. It is then passed through a sample 52, a lens 54 and into a group velocity dispersive medium 56 which is a low loss single mode optical fiber. State of the Art optical fibers have losses as small as 1.0 DB/Km of length, so for 1% transmission, L can be as long as 20Km. Experimental single mode fibers with attenuations as low as 0.2 DB/Km at 1.55 micro m have been fabricated. Typical values of $V_G^2 (\partial V_G/\partial\lambda)^{-1}$ are of the order of 30Km-nm/nsec. Thus for $\tau_{eff}$ = 300 psec, $\delta\lambda$=0.5 nm can be achieved. While fiber development has aimed at minimizing dispersion effects in the past, it may be possible to further optimize fibers suitable for the method described herein which exhibit low loss and large dispersion. Signal emerging from the optical fiber is focused through lens 58 into fast detector 60 to provide time domain electrical signal 62. The necessary bandwidth of the detector 60 and signal processing electronics is one GHz, which is within the state of the art.

The method of this invention provides a means and device for obtaining a serial, time domain readout of information stored in a photochemical hole burning memory which utilizes a medium with broad hole widths. At present no suitable readout method exists for media with broad holes. In this type of memory, information is stored by the presence or absence of spectral holes burned in a broad inhomogeneous absorption band. Figure 4B shows the optical transmission as a function of optical frequency after holes have been burned. When amorphous host materials are utilized, typical inhomogeneous band widths are 20 nm and typical hole widths are 0.02 nm. Figure 4 illustrates the application of the method of the disclosure. The laser pulse width $\tau$ should be less than 300 psec, so that $\tau_{eff}$ will be detector- and electronics-limited to about 300 psec. The passband of the filter is set to be coincident with the inhomogeneous absorption bandwidth. The spectral content of the light impinging on the sample is modified by the presence of the holes in the inhomogeneous absorption band. Figures 4A and 4C show the spectrum of the light before and after the sample. It can be seen that for each hole of width $\Delta\lambda_i$ and center wavelength $\lambda_i$, there is a packet of transmitted light of center wavelength $\lambda_i$ and width $\Delta\lambda_i$. At this point all of the light packets are of duration $\tau$ and simultaneous in time.

The transmitted light is then passed through the optical fiber and again L=20 Km and $V_G^2(\partial V_G/\partial\lambda)^{-1}$=30 Km-nm/nsec are assumed. The light packets from adjacent hole locations become separated in the time domain provided that the wavelength separation between adjacent holes is greater than $\delta\lambda$=0.5 nm. Thus, in this example, the 40 bits of information which could be encoded by the presence or absence of discrete holes spaced by 0.5 nm in a 20 nm wide inhomogeneous absorption band can be read out in the time domain as a train of 300 psec duration pulses separated by 300 psec. The presence or absence of a particular pulse would indicate the presence or absence of the corresponding hole. The duration of the entire pulse train would be 12 nsec and the propagation time through the 20 Km fiber would be 100 μsec. This 100 μsec delay would not be a problem for serial data read out.

Although a preferred embodiment of this invention has been described, it is understood that numerous variations may be made in accordance with the principles of this invention.

**0089472**

Claims:

1. A method for the spectral analysis of short optical pulses characterized by

passing an input pulse (12, 20, 42) through a medium (14, 28, 56) with group velocity dispersion, and

measuring the resultant pulse train with a photodetector (16, 30, 60) to produce the optical power spectrum in the time domain of said input pulse.

2. A method as described in claim 1 whereby said medium is a low loss single mode optical fiber.

3. A method as described in claim 1 whereby said medium is a vapor with absorption lines close to the mean wavelength of the input pulse.

4. A method for the spectral analysis of short optical pulses characterized by

passing an input pulse (20, 42) through a sample medium (26, 52) to impress information on said pulse in terms of a variation of the optical power contained in each region of the optical frequency spectrum,

passing the pulse from said sample medium through a medium (28, 56) with group velocity dispersion, and

measuring the resultant pulse with a photodetector (30, 60) to produce the optical power spectrum in the time domain of said pulse from said sample medium.

5.    A method as described in claim 4 whereby said input
pulse (42) is provided by a mode-locked laser (40) focused
into and through a nonlinear medium (46) before it passes
the sample medium (52).

6.    A method as described in claim 5 whereby said input
pulse from said nonlinear medium is passed through an
interference filter (50).

7.    A method as described in claim 4 whereby said sample
medium (52) contains information stored by photochemical
holes burned into a broad absorption band.

FIG.1

FIG.2

0089472

FIG.3

4A)

INTENSITY

980    1000    1020    1040    λ(nm)

4B)

TRANSMISSION

PHOTOCHEMICAL HOLES

100%

0%

980    1000    1020    1040    λ(nm)

4C)

INTENSITY

980    1000    1020    1040    λ(nm)

4D)

SIGNAL

~300psec

Teff

FIG.4

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| X | ANALYTICAL CHEMISTRY, vol. 51, no. 3, 1979 W.B. WHITTEN et al. "Fiber optic waveguides for time-of-flight optical spectrometry", pages 417-419 * Page 417, first paragraph; page 418, first paragraph; figure 2 * | 1,2,4 | G 01 J  3/28 |
| X | ANALYTICAL CHEMISTRY, vol. 52, no. 1, 1980 W.B. WHITTEN et al. "Dual beam fiber optic time-of-flight spectrometer", pages 101-104 * Figure 1 * | 1,2 | |
| A | EP-A-0 040 677  (IBM) * Abstract * | 7 | |
| | | | **TECHNICAL FIELDS SEARCHED (Int. Cl. 3)** |
| | ----- | | G 01 J  3/28 |

The present search report has been drawn up for all claims

| Place of search BERLIN | Date of completion of the search 13-05-1983 | Examiner FUCHS R |
|---|---|---|